# EUROPEAN PATENT APPLICATION

(11) **EP 4 700 278 A1**
(43) Date of publication of application: **25.02.2026**
(21) Application number: 24195308.2
(22) Date of filing: 20.08.2024
(51) Int. Cl.: F21S 41/141, F21S 41/19, F21S 45/47, H01L 25/075, H10H 29/24, H10H 29/85, F21Y 105/10, F21Y 115/10

(54) **LIGHTING DEVICE, METHOD OF MANUFACTURING THE SAME, AND AUTOMOTIVE HEADLIGHT WITH THE SAME**

(71) Applicant: Lumileds LLC, San Jose, CA 95131 (US)
(72) Inventor: LEE, Sze Kuang, San José, 95131 (US); KANG, Chun Heng, San José, 95131 (US)
(74) Representative: Ungria López, Javier

(57) **Abstract**

According to the invention a lighting device (100) is provided, comprising: a lead frame arrangement (110) comprising at least two lead frame parts (112); an insulating support arrangement (120) supporting the lead frame arrangement; at least one light emitting element (130) in electrical contact with a first lead frame part and a second lead frame part of the at least two lead frame parts; a heatsink (140) and a support structure (150), wherein the insulating support arrangement and the support structure are arranged on a common surface (142) of the heatsink, and wherein each lead frame part of the lead frame arrangement comprises at least one corresponding contact pin (114) extending from each lead frame part in a direction towards the support structure, the at least one contact pin comprising a contact portion (116) being mounted to the support structure and a flexible portion (118) being arranged in between the contact portion and the rest of each lead frame part.

## Description

### FIELD OF THE INVENTION

The present disclosure relates to a lighting device such as e.g. a light source for an automotive headlight, to a method of manufacturing a lighting device, and to an automotive headlight.

### BACKGROUND OF THE INVENTION

Light emitting elements such as light emitting diodes, LEDs, may be used as, at least part of, light sources for automotive headlights. Since in particular arrangements of one or more light emitting elements, e.g. LED modules comprising one or more LEDs, may produce heat during their operation, it is desirable to provide means enabling efficient heat transfer away from the LEDs. To this end, LEDs may for example be mounted on a component formed from a suitable material with suitable thermal conductivity (a heatsink). When LEDs are mounted directly on a surface of such heatsink, electrical connections to the LEDs can be provided in form of so-called top contacts, e.g. by wire bonding electrical contacts onto a side of an LED facing away from the heatsink.

However, corresponding wire bonding solutions may not be desirable in certain situations, e.g. in view of construction complexity and durability.

Further, for example in case of automotive head lights, light emitting elements such as LEDs are usually provided in combination with optical components (reflective and/or diffractive components) for shaping light emitted from the light emitting elements to achieve e.g. suitable high beam and/or low beam characteristics. To this end, upon mounting e.g. components of an automotive headlight, light emitting elements need to be positioned within suitable tolerances.

### SUMMARY OF THE INVENTION

In view of this, it is an object of the present invention to provide a lighting device with a that allows guiding heat away from an area of operating at least one light emitting element. It is a further object of the present invention to provide such lighting device that further allows for an improved electrical connection of the at least one light emitting element. It is yet a further object of the present invention to provide a lighting device that enables positioning of the at least one light emitting element within the lighting device within suitable tolerances.

According to a first aspect of the invention, a lighting device is provided comprising: a lead frame arrangement comprising at least two lead frame parts; an insulating support arrangement supporting the lead frame arrangement; at least one light emitting element in electrical contact with a first lead frame part and a second lead frame part of the at least two lead frame parts; a heatsink and a support structure, wherein the insulating support arrangement and the support structure are arranged on a common surface of the heatsink, and wherein a respective lead frame part of the lead frame arrangement comprises at least one corresponding contact pin extending from the respective lead frame part in a direction towards the support structure, the at least one contact pin comprising a contact portion being mounted to the support structure and a flexible portion being arranged in between the contact portion and the respective lead frame part.

According to a second aspect of the invention, a method of manufacturing a lighting device, in particular according to the first aspect, is provided, the method comprising: providing a lead frame arrangement comprising at least two lead frame parts; providing an insulating support arrangement to support the lead frame arrangement; providing at least one light emitting element in electrical contact with a first lead frame part and a second lead frame part of the at least two lead frame parts; providing a heatsink and a support structure; providing respective lead frame parts of the lead frame arrangement with at least one corresponding contact pin extending from the respective lead frame part, the at least one contact pin comprising a contact portion mounted to the support structure and a flexible portion being arranged in between the contact portion the respective lead frame part; the method comprising a step of mounting the insulating support arrangement supporting the lead frame arrangement and the support structure to a common surface of the heatsink, wherein upon mounting the insulating support arrangement supporting the lead frame arrangement and the support structure to the common surface of the heatsink, the insulating support arrangement supporting the lead frame arrangement is moved relative to the support structure, wherein upon mounting the insulating support arrangement supporting the lead frame arrangement and the support structure to the heatsink, at least the flexible portion is deformed, thus allowing for the relative movement of the insulating support arrangement supporting the lead frame arrangement relative to the support structure.

According to a third aspect of the invention, an automotive headlight comprising the lighting device according to the first aspect is provided.

Exemplary embodiments of the first, second and third aspect of the invention may have one or more of the properties described below. The embodiments relating to a lighting device disclosed herein that are configured to perform or comprise performing a method step thereby also disclose the corresponding method. Furthermore, a disclosure of a method step also discloses the corresponding device capable of performing the method step.

In an exemplary embodiment, the lighting device corresponds to or comprises an LED module comprising one or more light emitting elements, in particular LEDs, e.g. an arrangement of one or more light emitting elements and corresponding components for mounting and/or electrically connecting the one or more light emitting elements. Thus, the lighting device may be understood as corresponding to or comprising a light source for an automotive headlight. In an exemplary embodiment, an automotive headlight comprises primary and/or secondary optics (reflective and/or refractive, e.g. mirror optics and/or one or more lenses) arranged with respect to the one or more light emitting element to shape light emitted from the at least one light emitting element and to thus form a light beam suitable for automotive applications (e.g. high beam and/or low beam) when the one or more light emitting elements emit light. An automotive headlight may comprise further components, e.g. a housing, a fan for cooling in particular the one or more light emitting elements, and/or electrical components for controlling the one or more light emitting elements, and/or electrical connection means, e.g. plug connections, for connecting the automotive headlight to an electrical power source of a car.

In an exemplary embodiment, the lead frame arrangement of the lighting device is formed from or comprises a metal material and may be used as part of connection means for connecting the at least one light emitting element to a power source, e.g. to said power source of a car. The lead frame arrangement comprises at least two lead frame parts. In an exemplary embodiment, the at least one light emitting element is arranged on the lead frame arrangement in part on the first lead frame part and in part on the second lead frame part (of the at least two lead frame parts), e.g. being in electrical contact with the first lead frame part and the second lead frame part. Thereby, in an exemplary embodiment, the at least one light emitting element is arranged in direct mechanical contact with the first lead frame part and the second lead frame part, e.g., the at least one light emitting element may be soldered or glued to first lead frame part and the second lead frame part.

In an exemplary embodiment, a respective pair of the at least two lead frame parts, e.g. said first lead frame part and said second lead frame part, provides mutually different electrical polarities (positive/negative) for electrical connection of the at least one light emitting element. Thus, for example the first lead frame part and the second lead frame part may provide respective electrical contacts of positive and negative electrical polarity for contacting the at least one light emitting element. The at least one light emitting element being arranged in part on the first lead frame part and in part on the second lead frame part, these parts forming respective electrical contacts, it becomes possible to electrically contact the at least one light emitting element in an advantageous way. On the one hand, top contacts to the at least one light emitting element using, often fragile, wire bonding means can be avoided. On the other hand, providing the at least one light emitting element arranged on said parts of the lead frame arrangement, a non-complex, compact and durable construction enabling a reliable electrical contact can be achieved.

Thereby, a respective contact pin extending from the respective lead frame part in a direction towards the support structure may be used for electrically connecting the corresponding lead frame part to said power source. To this end, the contact portion of the at least one contact pin mounted to the support portion is in an exemplary embodiment mounted to the support structure in electrical contact with a corresponding further electrical contact provided on the support structure. The support structure is in an exemplary embodiment a component of the lighting device supporting the lead frame arrangement and the insulating support arrangement. In an exemplary embodiment, the lead frame arrangement supported by the insulating support arrangement is mounted to the support structure by means of the at least one contact pin. In other words, the at least one contact pin is in an exemplary embodiment provided for electrically connecting the at least one light emitting element to a power source and for mechanically connecting the lead frame arrangement to the support structure.

The support structure may thus correspond to a component of the lighting device for providing mechanical support and electrical connection. For example, in an exemplary embodiment, the support structure at least in part corresponds to or comprises a printed circuit board, PCB, and/or a printed wiring board, PWB. Thus, said further electrical contact may be a contact of said PCB and/or PWB and the at least one light emitting element may be electrically connected to said power source via said PCB and/or PWB.

The insulating support arrangement supports the lead frame arrangement. In other words, in an exemplary embodiment, the lead frame arrangement is mounted, in particular directly attached, to the insulating support arrangement. For example, in an exemplary embodiment, each one of the at least two lead frame parts is mounted to, in particular directly attached to, the insulating support arrangement, whereby the at least two lead frame parts are electrically insulated with respect to each other by means of the insulating support arrangement. For example, in an exemplary embodiment, the at least two lead frame parts are mounted to the insulating support arrangement being spaced apart from each other, whereby at least one gap formed between the at least two lead frame parts may at least in part be filled with an insulating material, e.g. with a portion of the insulating support arrangement. The insulating support arrangement may for example correspond to or comprise a support plate formed from an insulating material to which the at least two lead frame parts are mounted. In addition or alternatively, the insulating support arrangement may correspond to or comprise a molded component at least in part encapsulating at least one of the at least two lead frame parts. The insulating support arrangement may thus spatially separate the at least two lead frame parts and may thereby prevent electrical short circuits. Further, the insulating support arrangement may in addition or alternatively provide an electrical insulation of the lead frame arrangement with respect to the heatsink.

The insulating support arrangement may be formed from a suitable material enabling said electrical insulation properties preventing short circuits between the at least two lead frame parts or between the lead frame arrangement and the heatsink. For example, in an exemplary embodiment, the insulating support arrangement comprises an epoxy material, e.g. the insulating support arrangement may at least in part be formed as epoxy packaging mold. In addition, since heat generated by the at least one light emitting element when operating is transferred to the lead frame arrangement and thus to the insulating support arrangement, it turned out to be advantageous to provide the insulating support arrangement from a material enabling suitable heat transfer, in particular to the heatsink. In an exemplary embodiment, the insulating support arrangement comprises a heat conductive insulator material, e.g. a heat conductive plastic material, e.g. a heat conductive silicone material and/or a heat conductive epoxy material. On the one hand, use of such heat conductive insulator material may support heat transfer away from the at least one light emitting element. On the other hand, such thermal conductive property may help to enhance a lifetime of the insulating support arrangement.

The lighting device comprises said heatsink which, in an exemplary embodiment, is provided to transfer heat generated upon operation of the at least one light emitting element. To this end, the heatsink may be formed, at least in part, from a heat conductive material, in particular from a metal material and/or may correspond to a component comprising a metal material. In an exemplary embodiment, the heatsink may thus comprise at least one material selected from copper, aluminum, and/or alloys of copper and/or aluminum. Use of such material may be advantageous in that heat is guided away from the at least one light emitting element in a particularly efficient manner.

The insulating support arrangement and the support structure are arranged on said common surface of the heatsink. Thereby, the insulating support arrangement is in an exemplary embodiment arranged at least in part in contact with the heatsink. For example, in an exemplary embodiment, the insulating support arrangement comprises at least one spacer portion arranged in between the heatsink and the lead frame arrangement. In an exemplary embodiment, the at least one spacer portion may extend from the insulating support arrangement towards the heatsink and be in contact with the heatsink. For example, in an exemplary embodiment, the at least one spacer portion is arranged in between the heatsink and the lead frame arrangement such that an insulation gap is formed between the heatsink and the lead frame arrangement. Thereby, the at least one spacer portion may be arranged within said insulation gap. For example, the insulation gap may be formed at least in part in between two of the at least one spacer portion. The insulation gap may in addition or alternatively extend at a side of the at least one spacer portion.

To further enhance transfer of heat away from the at least one light emitting element towards the heatsink, in an exemplary embodiment, the insulating support arrangement is in an exemplary embodiment arranged at least in part in contact with the heatsink via an insulating thermal interface layer. In an exemplary embodiment, the insulating thermal interface layer comprises an electrically insulating thermally conductive material, e.g. a thermally conductive paste or a thermally conductive adhesive. Such thermally conductive material may for example comprise a silicone based material, e.g. a silicone based adhesive material.

For example, said at least one spacer portion may contact the heatsink via said insulating thermal interface layer. In an exemplary embodiment, the insulating thermal interface layer is arranged at least in part within the insulation gap in direct contact with the heatsink and the lead frame arrangement. The insulating thermal interface layer comprising an electrically isolating, thermally conductive material, the insulating thermal interface layer may advantageously contribute to a transfer of heat via the at least one spacer portion while an electrical isolation of the lead frame arrangement with respect to the heatsink is maintained. In an exemplary embodiment, a thickness of the insul (ation gap is smaller than a maximum thickness of the lead frame arrangement. Keeping a thickness of the insulation gap small may help to enhance heat transfer from the insulating support arrangement to the heatsink while a thickness of the insulation gap should be sufficiently large to allow for the described electrical insulation. It turned out that the thickness of the insulation gap is in an exemplary embodiment two times smaller, in particular three times smaller, in particular five times smaller than a maximum thickness of the lead frame arrangement

The at least one contact pin comprises a flexible portion arranged in between the contact portion and the respective lead frame part, e.g., forming an essentially central portion of the at least one contact pin. Being flexible, in particular the flexible portion of the at least one contact pin is configured to be deformed when, at least in an unmounted condition of the lighting device, the insulating support arrangement supporting the lead frame arrangement is moved relative to the support structure. While further parts of the contact pin may at least in part be bent as well to some extent, thus also allowing for said movement, a skilled person will recognize that the provision of such flexible portion enables at least a main deformation to be concentrated within this flexible portion. The provision of such flexible portion thus not only allows for such relative movement, it may also help to prevent damage to different portions of a contact pin that may otherwise be damaged by being bent beyond corresponding limits of such portions.

For example, upon mounting the insulating support arrangement supporting the lead frame arrangement and the support structure to the heatsink, the insulating support arrangement supporting the lead frame arrangement and the support structure may at first be moved towards the heatsink until the insulating support arrangement comes into contact with the heatsink. When the insulating support arrangement supporting the lead frame arrangement comes into contact with the heatsink before the support structure, a movement of the insulating support arrangement supporting the lead frame arrangement with respect to the heatsink may be stopped while a movement of the support structure towards the heatsink may still continue. This continued movement of the support structure while a movement of the insulating support arrangement is stopped corresponds to an example of a relative movement between the insulating support structure supporting the lead frame arrangement and the support structure. This relative movement is possible as the flexible portion of the at least one contact pin is configured to be deformed upon such movement. Thus, such relative movement is enabled by a deformation of the flexible portion of the at least one contact pin, the at least one contact pin extending from the lead frame arrangement and having a contact portion being mounted to the support structure. In other words, by means of the flexible portion, the at least one contact pin, which mechanically connects the lead frame arrangement supported by the insulating support arrangement with the support structure, is configured to allow for said relative movement. It is noted that for mechanically connecting the lead frame arrangement supported by the insulating support arrangement with the support structure, the contact portion of the contact pin is mounted to the support structure, e.g. is arranged on one side of the support structure being mounted to this side and/or is arranged on a side opposing said one side of the support structure (i.e. underneath the support structure as mentioned herein), and/or is mounted to an edge of the support structure connecting said one side and said opposing side of the support structure. The contact portion can be mounted to a side and/or an edge of the support structure, e.g. by soldering and/or gluing, or by different suitable means to establish at least a mechanical connection to said side and/or edge of the support structure.

Said continued movement of the support structure is eventually stopped, when the support structure arrives at said common surface of the heatsink. In this way, the insulating support arrangement and the support structure are mounted to the common surface of the heat sink, whereby an alignment of these components within a direction perpendicular to said common surface (a z-direction) is automatically achieved (z-alignment).

When the insulating support arrangement and the support structure are arranged on said common surface of the heatsink, in an exemplary embodiment, a gap is formed at least in between at least part of the insulating support arrangement and at least a corresponding part of the support structure. Thereby, in an exemplary embodiment, the support structure is arranged on the heatsink at least on two opposing sides of the insulating support arrangement, wherein a gap is formed at least in between each of the two opposing sides of the insulating support arrangement and the support structure. Such gap may allow for a relative movement of these components in said z-direction and thus for a corresponding alignment during a mounting process. In an exemplary embodiment, the support structure is arranged on the heatsink surrounding the insulating support arrangement. Thus, the insulating support arrangement may be arranged within a recess of the support structure.

In an exemplary embodiment, a respective lead frame part comprises at least two contact pins of same electrical polarity. Thus, for a respective polarity, the respective lead frame part may be connected to the support structure with at least two contact pins which may help to enforce a mechanical connection between the respective lead frame part and the support structure. In an exemplary embodiment, at least one of the at least two contact pins extends from each of two opposing sides of the respective lead frame part in a direction towards the support structure, the at least one of the at least two contact pins comprising a contact portion being mounted to (e.g. arranged on and/or underneath) the support structure and a flexible portion being arranged in between the contact portion and the respective lead frame part.

In other words, at least a first contact pin of the at least two contact pins may extend from the respective lead frame part in a first direction towards the support structure and at least a second contact pin of the at least two contact pins may extend from the respective lead frame part in a second direction towards the support structure, wherein the second direction may be different from the first direction, e.g. opposite to the first direction. Supporting two such contact pins extending from opposing sides of the lead frame arrangement in respective opposing directions on two respective portions of the support structure, the lead frame arrangement may be suspended e.g. within a recess of the support structure. In this way, with the lead frame arrangement being supported by the insulating support arrangement, the insulating support arrangement and the lead frame arrangement can be mounted to the support structure, in particular within said recess, in a mechanically reliable way which still allows sufficient flexibility by means of the respective flexible portions to enable said relative movement between the insulating support arrangement and the support structure described herein. In an exemplary embodiment, the at least one contact pin extends from the respective lead frame part across the gap formed in between the at least part of the insulating support arrangement and the corresponding part of the support structure towards the support structure.

In an exemplary embodiment, the flexible portion of the at least one contact pin and/or of the at least one of the at least two contact pins is a spring portion configured to, at least in unmounted condition of the lighting device, allow for a relative movement of the insulating support arrangement supporting the lead frame arrangement when the contact portion of the at least one contact pin and/or of the at least one of the at least two contact pins is (being) mounted to (e.g. arranged on and/or underneath) and/or mounted to and/or brought into contact with the support structure. For example, such spring portion may be formed by suitably bending at least a section of the flexible section, at least in part into a u-shape, a v-shape and/or an s-shape formed within a two-dimensional plane and/or within three dimensions. In other words, in an exemplary embodiment, the spring portion at least in part comprises an s-shape, a v-shape and/or a u-shape, in particular formed within a two-dimensional plane and/or in three dimensions. Such spring portion may in addition or alternatively comprise one or more suitable shapes, such as a shape of a compression spring.

Thereby, in an exemplary embodiment, a movement of the insulating support arrangement supporting the lead frame arrangement deforms the spring portion, causing the spring portion to exert a spring force to act against the movement of the insulating support arrangement supporting the lead frame arrangement. The spring force may persist (at least temporarily) in a mounted state in which the insulating support arrangement and the lead frame arrangement are mounted to the heatsink and may enhance a mechanical contact between the insulating support arrangement and the heatsink.

While, as described, the flexible portion of the at least one contact pin, in particular said spring portion, may enable an automatic alignment of the insulating support arrangement supporting the lead frame with respect to the support structure upon mounting the support structure and the insulating support arrangement to the heatsink, the lighting device may comprise further alignment features for facilitating an alignment of components within a plane parallel to a main surface of the heatsink, i.e. said common surface of the heatsink to which the insulating support arrangement and the support structure are mounted (x-y alignment).

To this end, in an exemplary embodiment, the lighting device further comprises at least one alignment arm comprising a first alignment member, wherein the alignment arm extends from the lead frame arrangement and the support structure comprises a corresponding second alignment member. In the exemplary embodiment, the first alignment member is an alignment pin, and the second alignment member is an alignment opening, or the first alignment member is an alignment opening and the second alignment member is an alignment pin.

In an exemplary embodiment, the alignment pin and the alignment opening are shaped such that the alignment pin can be inserted into the alignment opening. Thereby, the alignment opening may be formed as an alignment hole which may be advantageous as such hole may limit a movement of the alignment pin in two perpendicular directions, thereby enabling an advantageous x-y alignment as described further herein. Alternatively, the alignment opening can be formed as or comprise a linear alignment recess which may still allow for an alignment at least in one direction within a plane parallel to the common plane (x- or y- alignment).

Upon mounting the insulating support arrangement and the support structure to the heatsink, the alignment pin is at least temporarily in part arranged movably within the alignment opening. Being arranged movably within the alignment opening, the alignment pin is arranged movably with respect to the alignment opening in a direction essentially perpendicular to the common plane of the heatsink while movements in directions perpendicular to this direction are limited or restricted, in particular prevented, by corresponding side walls of the alignment opening which the alignment pin abuts upon such movement in directions perpendicular to this direction. Thus, these alignment members in form of alignment pin and alignment opening may facilitate a relative alignment of the insulating support arrangement supporting the lead frame with respect to the support structure in a plane parallel to the common surface of the heatsink.

In an exemplary embodiment, upon mounting of the insulating support arrangement and the support structure to the heatsink, the alignment pin is moved relative to the alignment opening, wherein in mounted condition of the insulating support arrangement and the support structure with the heatsink, the alignment pin is at least in part retained in the alignment opening. In particular, in an exemplary embodiment, the alignment pin is provided with sufficient length to retain a position of the alignment pin at least partially within the alignment opening. As described above, while the alignment pin is retained in the alignment opening, a movement of the alignment pin parallel to the common surface of the heatsink may be restricted by the alignment opening. Thus, an x-y-alignment in a plane parallel to the common surface of the heatsink may be maintained by retaining the alignment pin at least partially in the alignment opening.

The features and example embodiments of the invention described above may equally pertain to the different aspects according to the present invention. In particular, with the disclosure of features relating to the lighting device according to the first aspect, also corresponding features relating to the automotive headlight according to the second aspect are disclosed.

It is to be understood that the presentation of embodiments of the invention in this section is merely exemplary and non-limiting.

Other features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims. It should be further understood that the drawings are not drawn to scale and are merely intended to conceptually illustrate the structures and procedures described herein.

### BRIEF DESCRIPTION OF THE DRAWINGS

Examples of the invention will now be described in detail with reference to the accompanying drawings, in which:
- Fig. 1: exemplarily illustrates a lead frame arrangement and an insulating support arrangement according to an embodiment of the invention;
- Fig. 2: exemplarily illustrates the lead frame arrangement and the insulating support arrangement of Fig. 1 mounted to a support structure;
- Fig. 3a: illustrates a first cross-sectional view of a lead frame arrangement and of an insulating support arrangement according to an embodiment of the invention before being mounted to a heatsink;
- Fig. 3b: illustrates the cross-sectional view of the components of Fig. 3a when mounted to a heatsink;
- Fig. 4a: illustrates a second cross-sectional view of a lead frame arrangement and of an insulating support arrangement according to an embodiment of the invention before being mounted to a heatsink;
- Fig. 4b: illustrates the cross-sectional view of the components of Fig. 4a when mounted to a heatsink.

### DETAILED DESCRIPTION OF THE EMBODIMENTS

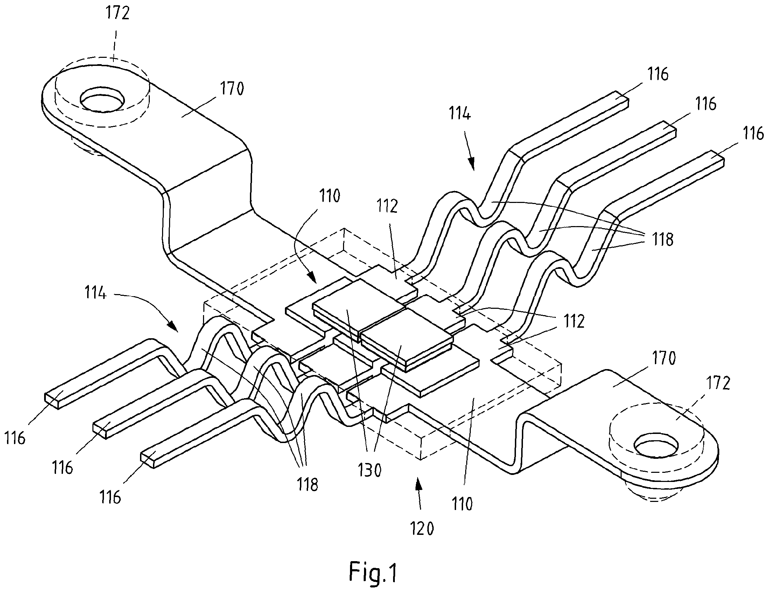

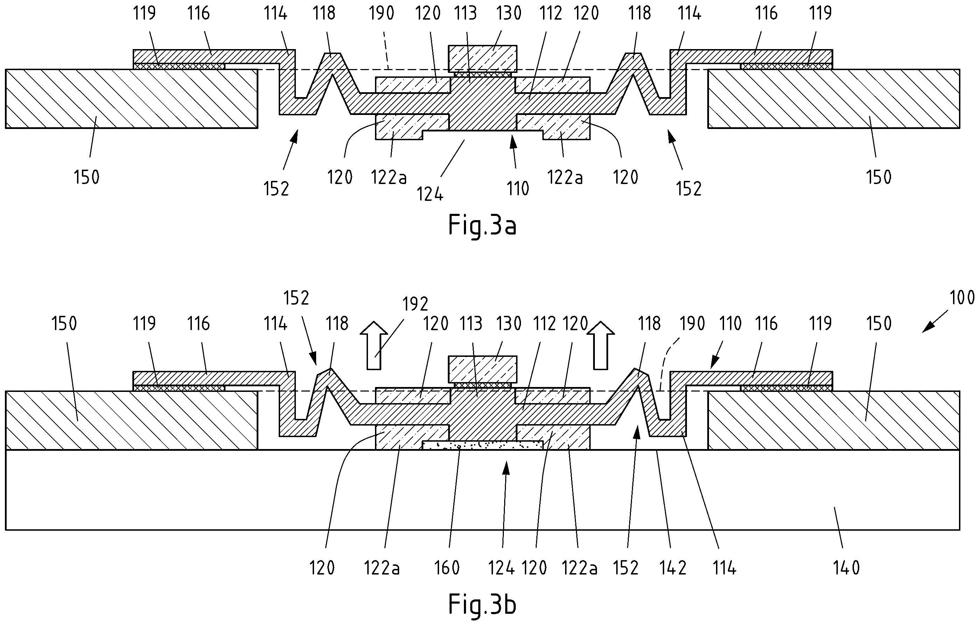

Figure 1 shows an example of a lead frame arrangement 110 and of an insulating support arrangement 120 (illustrated by means of dashed lines in the figure) according to an exemplary embodiment of the invention. In the shown example, the lead frame arrangement 110 comprises three lead frame parts 112. The lead frame parts 112 are mounted to the insulating support arrangement 120 being separated from each other to ensure mutual electrical insulation. The insulating support arrangement 120 supporting the lead frame arrangement 110 is a molded component encapsulating respective parts of the lead frame arrangement 110, whereby elevated contact portions 113 (see e.g. Fig. 3a) protrude the insulating support arrangement 120 to provide respective electrical contacts for two light emitting diodes, LEDs, 130 (respective examples of the at least one light emitting element) shown in Fig. 1.

As shown in the figure, each of the two LEDs 130 is arranged in part on and in electrical contact with a central one of the three lead frame parts 112 and each of the two LEDs 130 is arranged in part on and in electrical contact with a respective one of the two outer ones of the three lead frame parts 112. Thereby, the outer ones of the three lead frame parts 112 may provide electrical contacts of same electrical polarity, this electrical polarity being opposed to the electrical polarity of the central one of the three lead frame parts 112. As it will be clear for a person skilled in the art, the exemplary embodiment shown in Fig. 1 may be expanded by adding more LEDs 130 and respectively more lead frame parts 112. In addition or alternatively, more than one LED may be provided at least in part arranged on a same pair of lead frame parts.

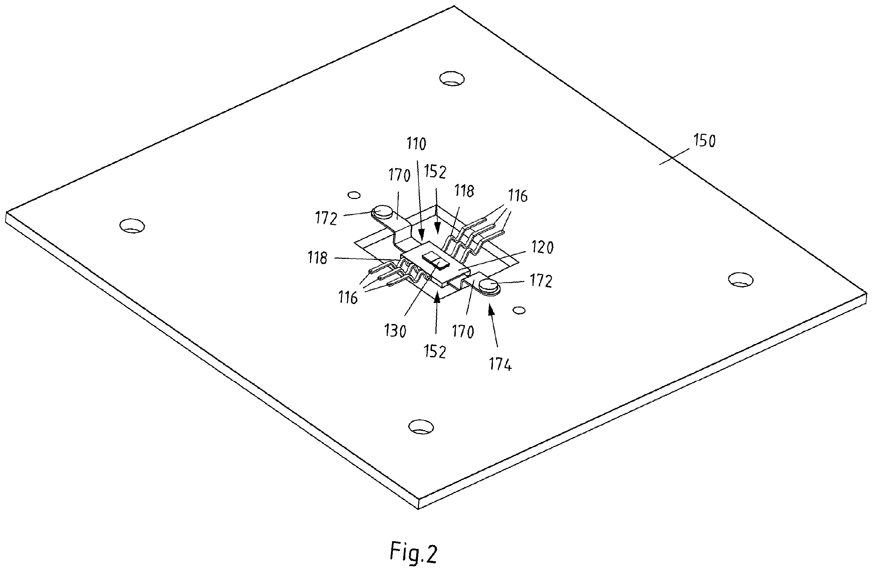

Figure 1 further shows respective pairs of contact pins 114 extending from respective opposing sides of each one of the respective lead frame parts 112 in mutually opposing directions away from the lead frame arrangement 110. In the shown embodiment, a respective contact pin 114 comprises a contact portion 116 to be arranged on the support structure 150 (see Fig. 2).

Alternatively, or in addition, a contact portion of a respective contact pin can in exemplary embodiments be mounted to the support structure 150, being arranged underneath the support structure 150, mounted to the support structure 150 from below. For example, all contact pins can be provided with respective contact portions to be mounted to the support structure from one side (e.g. to be arranged on a top surface of the support structure as shown in Fig. 2), all contact pins can be provided with respective contact portions to be mounted to the support structure from the other side (e.g. to be arranged on a bottom surface of the support structure opposing the top surface thereof shown in Fig. 2), or one or more of the contact portions can be provided on one side of the support structure, while one or more of the contact portions can be provided on the other side of the support structure. Yet in addition or alternatively, one or more of the contact portions can in an exemplary embodiment be mounted at least on part to an edge of the support structure (e.g. soldered thereto) and/or can be mounted to one surface and to an opposing surface of the support structure 150.

As shown, a respective contact pin 114 further comprises a flexible portion 118 in between the contact portion 116 and the respective lead frame part 112. The flexible portion 118 corresponds to a spring portion comprising an s-shape allowing for a movement of the corresponding contact portion 116 with respect to the corresponding lead frame portion 112 by being deformed/bent upon such movement. It is noted that part of the shown s-shape also comprises a u-shape which by itself could be sufficient to provide a spring portion depending on the application and/or circumstances. In this way, the shown plurality of flexible portions 118 allows for a movement of the lead frame arrangement 110 and the insulating support arrangement 120 with respect to the support structure 150 when mounted thereto as shown in Fig. 2.

Figure 1 further shows two alignment arms 170 comprising an alignment pin 172, wherein the alignment arms 170 extend from the lead frame arrangement 110 in opposite directions.

Figure 2 shows the lead frame arrangement 110 and the insulating support arrangement 120 of Fig. 1 mounted to a corresponding support structure 150. While the support structure 150 is schematically shown in the figure as a plain support plate, an illustration of further connectors for connecting the LEDs 130 via the contact pins with contact portions 116 to a power source, an illustration of such further connectors is omitted only for simplicity of the illustration. As a skilled person will understand, such further connectors can be provided e.g. on the surface of the support structure 150 as shown in Fig. 2 in contact with contact portions 116. Alternatively or in addition, support structure 150 may be understood as a purely schematic illustration of a printed circuit board (PCB), or printed wiring board (PWB), providing such further connectors in contact with contact portions 116.

Figure 2 shows the insulating support arrangement 120 being arranged within a recess of support structure 150, a gap 152 being formed between each of four sides of the insulating support arrangement 120 and the support structure 150. The support structure 150 is thus arranged surrounding the insulating support arrangement 120. Such arrangement advantageously allows for the insulating support arrangement 120 with the lead frame arrangement 110 to be suspended by means of contact pins 114 on opposing faces of the support structure 150. As shown, contact pins 114 extend from each of two opposing sides of the lead frame arrangement 110 (not visible in the figure) encapsulated by the insulating support arrangement 120 in respective directions towards the support structure 150, the contact pins 114 comprising a contact portion 116 being mounted to, in the shown case arranged on, the support structure 150. The contact pins 116 may e.g. be soldered to the support structure 150 in contact with corresponding further connectors (not shown in the figure).

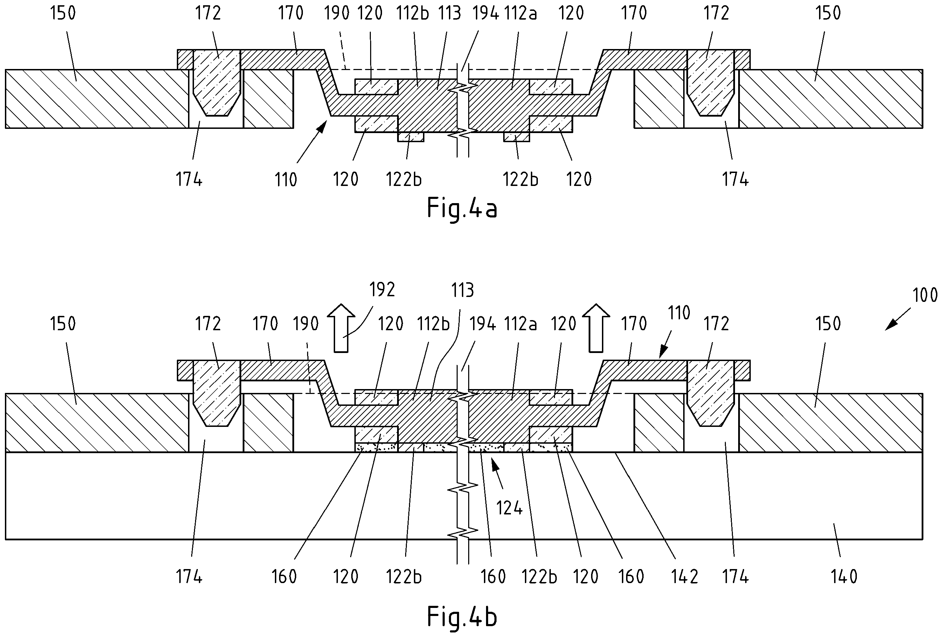

As further shown in Fig. 2, the two alignment arms 170 are similarly arranged on opposing faces of the support structure 150 with the respective alignment pins 172 being retained in corresponding alignment openings (indicated by arrow 174 in Fig. 2, see also Fig. 4a).

Figure 3a shows a cross-sectional view along a lead frame part 112. The insulating support arrangement 120 partly surrounds or encapsulates the lead frame part 112. The lead frame part 112 comprises two contact pins 114 extending from opposite ends of the lead frame part 112. The contact pins 114 comprise a contact region 116 attached to the support structure 150 through an electrically conductive glue or solder 119. The contact pins 114 further comprise a flexible region 118 arranged in between the contact region 116 and the lead frame part 112 within gap 152.

Further shown is a bottom-contact LED 130, wherein the bottom-contact LED 130 is electrically contacted through the lead frame arrangement 110 from below the bottom-contact LED 130. As illustrated in the figure, in an exemplary embodiment, the at least one light emitting element 130 comprising a bottom-contact LED is in contact with a respective lead frame part 112 via a corresponding elevated contact portion 113 protruding through the insulating support arrangement 120.

The insulating support arrangement 120 comprises two spacer portions 122a arranged at a side of the lead frame arrangement 110 opposing a side to which the LEDs 130 are mounted. As shown, an insulation gap 124 is thereby formed between the two spacer portions 122a. As further shown, the insulation gap 124 is arranged below elevated contact portion 113.

In order to compare Figs. 3a and 3b, a line 190 schematically shows a height of a top surface of the support structure 150. As shown, in the situation shown in Fig. 3a in which the insulating support arrangement 120 supporting the lead frame arrangement 110 and the support structure 150 are not mounted to the lead frame 140, the insulating support arrangement 120 is arranged below said comparative line 190.

Figure 3b shows the components shown in Fig. 3a mounted to a heatsink 140, whereby the cross-sectional view shown in Fig. 3b corresponds to the cross-sectional view shown in Fig. 3a. As shown, the insulating support arrangement 120 and the support structure 150 are arranged on a common surface 142 of the heatsink 140. As a result of the mounting process described herein, the insulating support arrangement 120 supporting the lead frame arrangement 110 has been moved relative to the support structure 150 (upwards in the figure) upon mounting of the insulating support arrangement 120 and the support structure 150 to the heatsink 140. This movement is schematically indicated by arrows 192 in the figure. Compared to Fig. 3a, the insulating support arrangement 120 has been moved upwards in the figure such that a top surface of the insulating support arrangement 120 is on a similar height level as the top surface of the support structure 150 as illustrated by the comparative line 190. Thereby, the flexible portions 118 of the contact pins 114 have been deformed to account for the relative movement of the insulating support arrangement 120 to the contact region 116. Thus, the embodiment shown in Figs. 3a and 3b allows for an automatic z-alignment of the insulating support arrangement 120 and the LED 130 upon mounting of the insulating support arrangement 120 and the support structure 150 to the same surface 142 of heatsink 140.

The spacer portions 122a are arranged in between the heatsink 140 and the lead frame arrangement 110 such that said insulation gap 124 is formed between the heatsink 140 and the lead frame arrangement 110. As shown in Fig. 3b, the lighting device further comprises an insulating thermal interface layer 160 arranged in the insulation gap 124 in direct contact with the heatsink 140 and the lead frame arrangement 110. Thus, the lead frame arrangement 110 is electrically insulated from the heatsink while maintaining a good thermal conductivity from the lead frame arrangement 110 to the heatsink 140 which may further be enhanced by the thermal interface layer 160.

A thickness of the insulation gap 124 is thereby smaller than a maximum thickness of the lead frame arrangement 110. Thus, the bottom-contact LED 130 is arranged close to heatsink 140 which enables an efficient heat transfer from the bottom-contact LED 130 to heatsink 140.

Figure 4a shows a cross-sectional view along alignment arms 170 shown in Fig. 1, whereby central parts of the lighting device are not illustrated as indicated by cut section 194. The insulating support arrangement 120 partly encapsulates the lead frame arrangement 110. The figure shows a first one 112a of the two outer ones of the three lead frame parts 112 shown in Fig. 1 and a second one of the two outer ones of the three lead frame parts 112 shown in Fig. 1. As shown, lead frame parts 112a and 112b comprise an elevated contact portion 113 and in the figure, spacer portions 122b are arranged underneath said elevated contact portions 113. As can be taken from Fig. 4b, these spacer portions 122b are arranged within insulation gap 124 and the thermal interface layer 160 is arranged in between and at respective sides of spacer portions 122b.

A respective alignment arm 170 extends from each of lead frame parts 112a and 112b (see also Fig. 1). In this way, the alignment arms 170 extend from the lead frame arrangement 110 to the support structure 150. As shown in the figure, each of the alignment arms 170 comprises a respective alignment pin 172 (an example of a first alignment member). In correspondence, the support structure 150 comprises a corresponding alignment opening 174 (an example of a second alignment member, e.g. an alignment hole or an alignment recess).

As shown, the alignment pins 172 and the alignment openings 174 are shaped such that the alignment pins 172 can be inserted into the alignment openings 174. In particular, the alignment pins 172 comprise a tapered tip to assist with an insertion of the alignment pins 172 into the alignment openings 174. At least in unmounted condition of the lighting device, as shown in Fig. 4a, and during mounting of the insulating support arrangement 120 and the support structure 150 to the heatsink 140, the alignment pins 172 are at least temporarily in part arranged movably within the alignment openings 174. As illustrated in Figs. 4a and 4b, being arranged movably within the alignment opening is to be understood that at least a movement of the alignment pin with respect to the alignment opening in a direction perpendicular to the common surface of the heat sink is not restricted by the alignment opening.

As in case of Fig. 3a, a comparative line 190 is shown also in Fig. 4a and accordingly, in case of Fig. 4a in which the insulating support arrangement 120 and the support structure 150 are not mounted to the heat sink 140, the insulating support arrangement 120 is arranged below said line 190.

Figure 4b shows the components of Fig. 4a mounted to the heatsink 140. In particular, the cross-sectional view shown in Fig. 4b corresponds to the cross-sectional view shown in Fig. 4a. The insulating support arrangement 120 and the support structure 150 are arranged on a common surface 142 of the heatsink 140. The insulating support arrangement 120 supporting the lead frame arrangement 110 has been moved upwards relative to the support structure 150 upon mounting of the insulating support arrangement 120 and the support structure 150 to the heatsink 140, as indicated by arrows 192. Compared to Fig. 4a, the insulating support arrangement 120 has been moved upwards, whereby also alignment arms 170 and alignment pins 172 have been moved upwards accordingly.

Thus, upon mounting of the insulating support arrangement 120 and the support structure 150 to the heatsink 140, the alignment pins 172 are moved relative to the alignment openings 174 in a direction perpendicular to the common surface 142 of heat sink 140 partially out of the alignment openings 174. Thereby, in mounted condition of the insulating support arrangement 120 and the support structure 150 with the heatsink 140, as shown in Fig. 4b, the alignment pins 172 nevertheless retained in the alignment openings 174 such that movements of the insulating support arrangement 120 relative to the support structure 150 are still restricted. The insulating support arrangement supporting the lead frame arrangement and thus the LEDs is thus kept in alignment. Thus, the alignment arms 170 facilitate an automative x-y alignment of the insulating support arrangement with respect to the support structure 150.

Therefore, components of a lighting device as shown in Figs. 3a and 4a may be arranged simultaneously on a heatsink 140 with a pick and place method, wherein the alignment arms 170 ensure an automated x-y alignment of the insulating support arrangement 120 with respect to the support structure 150 and wherein the flexible sections 118 ensure an automated z-alignment of the insulating support arrangement 120 with respect to the support structure 150.

As a result, the lighting device according to the first aspect described herein not only provides means enabling a beneficial heat transfer from the at least one light emitting element towards the heat sink via the lead frame arrangement and the insulating support structure, the lighting device further provides means enabling an (z and x-y) alignment of the insulating support arrangement supporting the lead frame and thus of the LEDs supported thereby which is achieved automatically while mounting the insulating support arrangement supporting the lead frame arrangement and the support structure onto a common surface of the heat sink.

**LIST OF REFERENCE SIGNS:**

| | |
|---|---|
| Lighting device | 100 |
| Lead frame arrangement | 110 |
| Lead frame part | 112 |
| First lead frame part | 112a |
| Second lead frame part | 112b |
| Elevated contact portion | 113 |
| Contact pin | 114 |
| Contact portion | 116 |
| Flexible portion | 118 |
| Electrically conductive glue or solder | 119 |
| Insulating support arrangement | 120 |
| Spacer portion | 122a, 122b |
| Insulation gap | 124 |
| Light emitting element | 130 |
| Heatsink | 140 |
| Surface of heatsink | 142 |
| Support structure | 150 |
| Gap | 152 |
| Insulating thermal interface layer | 160 |
| Alignment arm | 170 |
| Alignment pin | 172 |
| Alignment opening | 174 |
| Comparative line | 190 |
| Movement indicator arrows | 192 |
| Cut section | 194 |

## Claims

1. A lighting device (100) comprising:
- a lead frame arrangement (110) comprising at least two lead frame parts (112);
- an insulating support arrangement (120) supporting the lead frame arrangement (110);
- at least one light emitting element (130) in electrical contact with a first lead frame part (112) and a second lead frame part (112) of the at least two lead frame parts (112);
- a heatsink (140) and a support structure (150),
wherein the insulating support arrangement (120) and the support structure (150) are arranged on a common surface (142) of the heatsink (140), and wherein a respective lead frame part (112) of the lead frame arrangement (110) comprises at least one corresponding contact pin (114) extending from the respective lead frame part (112) in a direction towards the support structure (150), the at least one contact pin (114) comprising a contact portion (116) being mounted to the support structure (150) and a flexible portion (118) being arranged in between the contact portion (116) and the respective lead frame part (112).

2. The lighting device (100) according to claim 1, wherein the at least one light emitting element (130) is arranged on the lead frame arrangement (110) in part on the first lead frame part (112) and in part on the second lead frame part (112).

3. The lighting device (100) according to any of claims 1 or 2, wherein the support structure (150) is arranged on the heatsink (140) at least on two opposing sides of the insulating support arrangement (120), wherein a gap (152) is formed at least in between each of the two opposing sides of the insulating support arrangement (120) and the support structure (150); in particular wherein the support structure (150) is arranged on the heatsink (140) surrounding the insulating support arrangement (120).

4. The lighting device (100) according to any of claims 1 to 3, wherein a respective lead frame part (112) comprises at least two contact pins (114) of same electrical polarity.

5. The lighting device (100) according to claim 4, wherein at least one of the at least two contact pins (114) extends from each of two opposing sides of the respective lead frame part (112) in a direction towards the support structure (150), the at least one of the at least two contact pins (114) comprising a contact portion (116) being mounted to the support structure (150) and a flexible portion (118) being arranged in between the contact portion (116) and the respective lead frame part (112).

6. The lighting device (100) according to any of claims 1 to 5, wherein the flexible portion (118) of the at least one contact pin (114) is a spring portion (118) configured to, at least in unmounted condition of the lighting device (100), allow for a relative movement of the insulating support arrangement (120) supporting the lead frame arrangement (110), when the contact portion (116) of the at least one contact pin (114) is mounted to the support structure (150).

7. The lighting device (100) according to any of claims 1 to 6, wherein the spring portion (118) at least in part comprises a u-shape, a v-shape, and/or an s-shape.

8. The lighting device (100) according to any of claims 1 to 7, wherein the insulating support arrangement (120) comprises at least one spacer portion (122a, 122b) arranged in between the heatsink (140) and the lead frame arrangement (110) such that an insulation gap (124) is formed between the heatsink (140) and the lead frame arrangement (110).

9. The lighting device (100) according to claim 8, wherein a thickness of the insulation gap (124) is smaller than a maximum thickness of the lead frame arrangement (110).

10. The lighting device (100) according to any of claims 8 or 9, further comprising an insulating thermal interface layer (160) arranged at least in part within the insulation gap (124) in direct contact with the heatsink (140) and the lead frame arrangement (110).

11. The lighting device (100) according to any of claims 1 to 10, further comprising at least one alignment arm (170) comprising a first alignment member (172), wherein the alignment arm (170) extends from the lead frame arrangement (110), wherein the support structure (150) comprises a corresponding second alignment member (174),
wherein the first alignment member (172) is an alignment pin and the second alignment member (174) is an alignment opening, or wherein the first alignment member (172) is an alignment opening and the second alignment member (174) is an alignment pin,
wherein the alignment pin and the alignment opening are shaped such that the alignment pin can be inserted into the alignment opening; and
wherein upon mounting the insulating support arrangement (120) and the support structure (150) to the heatsink (140), the alignment pin is at least temporarily in part arranged movably within the alignment opening.

12. The lighting device (100) according to claim 11, wherein upon mounting of the insulating support arrangement (120) and the support structure (150) to the heatsink (140), the alignment pin is moved relative to the alignment opening, wherein in mounted condition of the insulating support arrangement (120) and the support structure (150) with the heatsink (140), the alignment pin is at least in part retained in the alignment opening.

13. A method of manufacturing a lighting device (100), in particular according to any of claims 1 to 12, the method comprising:
- providing a lead frame arrangement (110) comprising at least two lead frame parts (112);
- providing an insulating support arrangement (120) to support the lead frame arrangement (110);
- providing at least one light emitting element (130) in electrical contact with a first lead frame part (112) and a second lead frame part (112) of the at least two lead frame parts (112);
- providing a heatsink (140) and a support structure (150),
- providing respective lead frame parts (112) of the lead frame arrangement (110) with at least one corresponding contact pin (114) extending from the respective lead frame part (112), the at least one contact pin (114) comprising a contact portion (116) mounted to the support structure (150) and a flexible portion (118) being arranged in between the contact portion (116) the respective lead frame part (112);
the method comprising a step of mounting the insulating support arrangement (120) supporting the lead frame arrangement (110) and the support structure (150) to a common surface (142) of the heatsink (140), wherein upon mounting the insulating support arrangement (120) supporting the lead frame arrangement (110) and the support structure (150) to the common surface (142) of the heatsink (140), the insulating support arrangement (120) supporting the lead frame arrangement (110) is moved relative to the support structure (150),
wherein upon mounting the insulating support arrangement (120) supporting the lead frame arrangement (110) and the support structure (150) to the heatsink (140), at least the flexible portion (118) is deformed, thus allowing for the relative movement of the insulating support arrangement (120) supporting the lead frame arrangement (110) relative to the support structure (150).

14. The method of manufacturing a lighting device (100) according to claim 13, the method further comprising:
- providing at least one alignment arm (170) comprising a first alignment member (172), wherein the alignment arm (170) extends from the lead frame arrangement (110), wherein the support structure (150) comprises a corresponding second alignment member (174),
wherein the first alignment member (172) is an alignment pin, and the second alignment member (174) is an alignment opening, or wherein the first alignment member (172) is an alignment opening, and the second alignment member (174) is an alignment pin,
wherein the alignment pin and the alignment opening are shaped such that the alignment pin can be inserted into the alignment opening;
the step of mounting the insulating support arrangement (120) supporting the lead frame arrangement (110) and the support structure (150) to the common surface (142) of the heatsink (140) comprising:
- moving the alignment pin relative to the alignment opening, and
- retaining the alignment pin at least in part in the alignment opening.

15. Automotive headlight comprising the lighting device (100) according to any of claims 1 to 12.
